# EUROPÄISCHE PATENTSCHRIFT

(11) **EP 0 379 690 B1**
(45) Veröffentlichungstag und Bekanntmachung des Hinweises auf die Patenterteilung: **08.09.1993**
(21) Anmeldenummer: 89122927.0
(22) Anmeldetag: 12.12.1989
(51) Int. Cl.: H01J 37/153, H01J 37/145

(54) **Multipolelement**
Multi-pole element
Elément multipôle

(30) Priorität: 24.01.1989 DE 3901980
(43) Veröffentlichungstag der Anmeldung: 01.08.1990
(73) Patentinhaber: ICT Integrated Circuit Testing Gesellschaft für Halbleiterprüftechnik mbH, D-85551 Kirchheim (DE)
(72) Erfinder: Lanio, Stefan, Dr., D-6900 Heidelberg (DE); Haider, Maximilian, Dr., D-6100 Darmstadt (DE)
(74) Vertreter: Tetzner, Volkmar, Dr.-Ing. Dr. jur.

(56) Entgegenhaltungen:
- DE-A- 1 464 282
- DE-A- 2 555 744
- DE-A- 2 915 207
- US-A- 3 150 258

## Beschreibung

Die Erfindung betrifft ein multipolelement nach dem oberbegriff des Patentanspruchs 1, sowie ein Verfahren zu dessen Herstellung.

In konventionellen Elektronenmikroskopen, Elektronen- und Ionenstrahlschreibern, Ionenbearbeitungs- und Implantationsgeräten sowie Elektronenstrahlmeßgeräten werden Rundlinsen zur Fokussierung der Korpuskularstrahlen eingesetzt. Die Geometrie dieser rotationssymmetrische, elektrische und/oder magnetische Felder erzeugenden Linsen ist hierbei auf kleine Fehlerkonstanten optimiert. In Systemen, in denen ausschließlich rotationssymmetrische, zeitunabhängige und raumladungsfreie elektrische oder magnetische Felder die Linsenwirkung vermitteln, kann man den Öffnungsfehler dritter Ordnung und den axialen Farbfehler erster Ordnung ersten Grades prinzipiell nicht vollständig korrigieren. Eine Korrektur dieser die Auflösung begrenzenden Abbildungsfehler ist erst dann möglich, wenn eine der Einschränkungen bezüglich der Felder aufgegeben wird. Besonders erfolgversprechend ist der Übergang zu unrunden Abbildungssystemen, d. h. Abbildungssystemen die Multipolelemente zur Strahlformung aufweisen.

Einfache Multipolelemente (Quadrupole) finden beispielsweise als Justierhilfen oder Stigmatoren in jedem Elektronenmikroskop Verwendung. Für diese Elemente sind die Anforderungen bezüglich der Form der felderzeugenden Komponenten (Polschuhe, Elektroden), der Genauigkeit der Justierung zur optischen Achse und der Lang- und Kurzzeitstabilität allerdings wesentlich geringer als für Systeme zur Korrektur bzw. Verringerung von Abbildungsfehlern (Korrektoren), die beispielsweise aus mehreren hintereinander angeordneten, stark fokussierenden Multipolelementen bestehen. Diese müssen sehr genau zueinander justiert werden und dürfen nicht gegeneinander verschoben oder verdreht sein. Außerdem sollten die im Vakuum angeordneten Teile der Multipolelemente eine nicht ausgasende Oberfläche besitzen und vom Primärstrahl weder kontaminiert noch aufgeladen werden.

Bei den aus Optik 60, No. 3 (1982) Seite 307 bis 326 bekannten elektrisch-magnetischen Multipolelementen sind die im Vakuum angeordneten Teile, also insbesondere die Polschuhe, die auf den Polschuhhalterungen befestigten Erregerwicklungen und die Zuleitungen, in Kunstharz eingegossen, um die ausgasende Oberfläche zu verringern. Diese Einbettungstechnik besitzt allerdings den Nachteil, daß das Kunstharz trotz monatelanger Aushärtung unter Vakuum weiter ausgast, zudem schrumpft, versprödet und die magnetischen Eigenschaften des Multipolelements beeinflußt. Außerdem ist eine aufwendige Abschirmung notwendig, um eine Aufladung durch den Korpuskularstrahl zu vermeiden.

Der Erfindung liegt die Aufgabe zugrunde, ein Multipolelement der eingangs genannten Art anzugeben, bei dem möglichst wenige Teile im Vakuum angeordnet sind. Das Verfahren zur Herstellung des Multipolelements soll insbesondere eine präzise Fertigung der felderzeugenden Elemente erlauben. Diese Aufgaben werden erfindungsgemäß durch ein Multipolelement nach Patentanspruch 1 und durch ein Verfahren nach Patentanspruch 12 gelöst.

Der mit der Erfindung erzielbare Vorteil besteht insbesondere darin, daß nur die das elektrische und/oder magnetische Feld erzeugenden Elemente innerhalb des Strahlrohrvakuums angeordnet sind. Dies gewährleistet
- ein kleines Vakuumsystem.
- eine kleine Oberfläche der im Vakuum angeordneten Teile,
- keine nichtleitenden Oberflächen im Bereich des Korpuskularstrahls und
- einen mechanisch stabilen Aufbau.

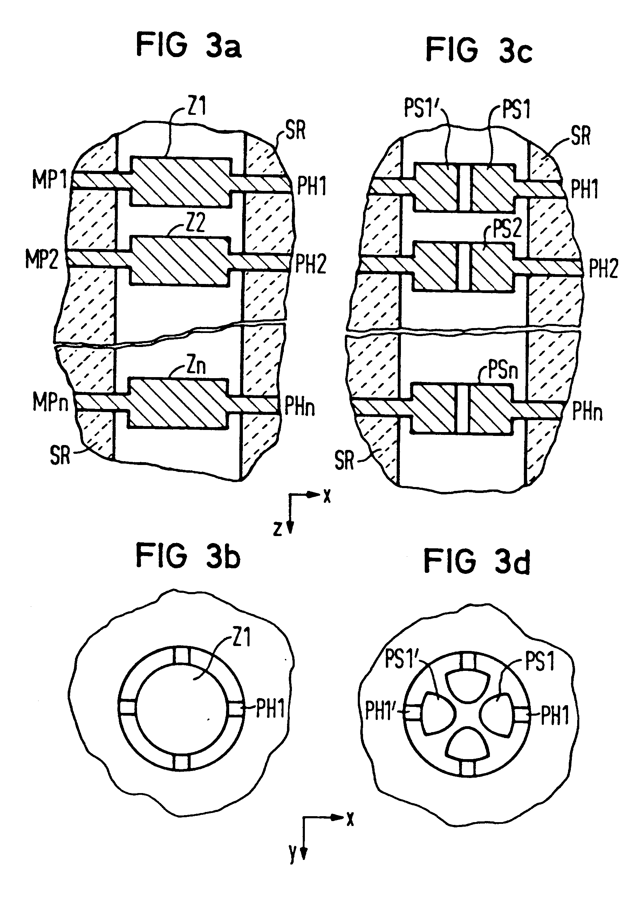

Die Unteransprüche betreffen vorteilhafte Weiterbildungen der Erfindung, die im folgenden anhand der Zeichnungen näher erläutert wird. In den Fig. 1 und 2 ist hierbei der schematische Aufbau eines erfindungsgemäßen Multipolelements dargestellt, während die Fig. 3 und 4 die zur präzisen Fertigung der felderzeugenden Elemente notwendigen Verfahrensschritte zeigen.

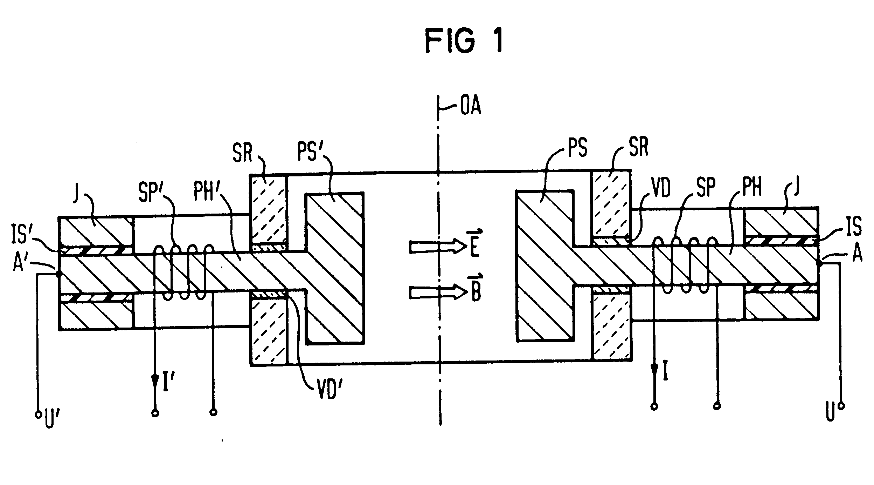

Das in Fig. 1 dargestellte elektrisch-magnetische Multipolelement kann insbesondere in einem Korrektor zur Verbesserung der Auflösung eines Elektronenstrahlmeßgeräts Verwendung finden. Es besitzt üblicherweise eine gerade Anzahl von Polschuhen PS, PS' (in Fig. 1 sind aus Gründen der Übersichtlichkeit nur 2 der beispielsweise 8 oder 12 Polschuhe dargestellt), die symmetrisch zur optischen Achse OA des Elektronenstrahlmeßgeräts angeordnet und durch stabförmige Halterungselemente PH, PH' starr mit dem ringförmigen Eisenkreis J (Joch) verbunden sind. Innerhalb des der Führung des magnetischen Flusses dienenden Jochs J ist ein koaxial zur optischen Achse OA angeordnetes Strahlrohr SR vorgesehen, das aus einem elektrisch isolierenden Material, vorzugsweise aus Keramik oder Aluminiumoxid besteht und vakuumdichte Durchführungen zur Aufnahme der mit den Polschuhen PS, PS' verschraubten, verklebten oder verlöteten Halterungselemente PH, PH' aufweist. Als Vakuumabdichtungen VD, VD' kommen Metall- Keramikverbindungen oder Metallkappen in Betracht, die auf einer im Bereich der Bohrungen vorhandenen Metallisierung aufgebracht und jeweils mit den aus einem magnetischen Material bestehenden Halterungselementen PH, PH' verlötet sind. Die zwischen dem Strahlrohr SR und dem Joch J liegenden Teile der Halterungselemente PH, PH' tragen die Spulen SP, SP' zur individuellen magnetischen Erregung der Polschuhe PS, PS'. Die in den Spulen SP, SP' fließenden Ströme I, I' sind hierbei so vorgegeben, daß sich innerhalb des evakuierten Strahlrohrs SR das gewünschte magnetische Multipolfeld 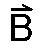 aufbaut. Zur Erzeugung eines elektrischen Multipolfeldes 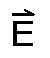 werden die Polschuhe PS, PS' mit den entsprechenden Potentialen U, U' beaufschlagt. Als Spannungszuführungen dienen die Halterungselemente PH, PH', die in den mit einem Isolator IS, IS' ausgekleideten Bohrungen des Jochs J geführt und jeweils mit elektrischen Anschlüssen A, A' verbunden sind.

Das Stahlrohr SR kann auch aus einem leitfähigen Material, also insbesondere aus Metall bestehen, wenn man Isolatoren als Vakuumdichtungen VD, VD' verwendet.

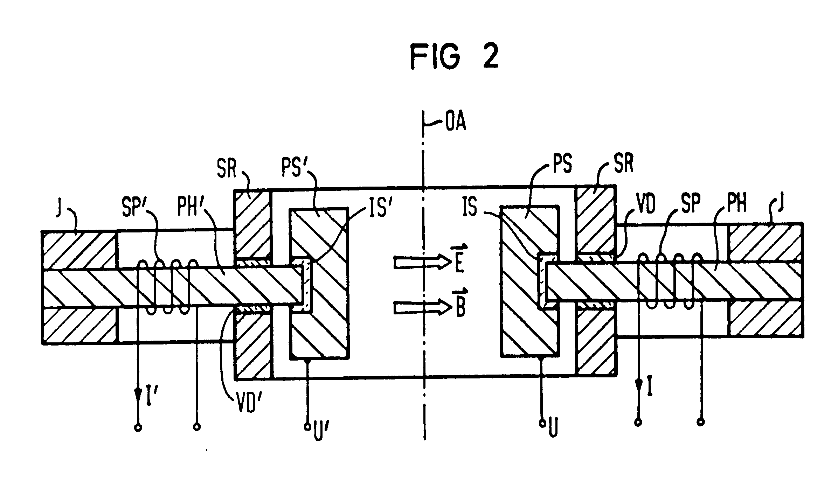

Bei dem in Fig. 2 dargestellten Ausführungsbeispiel eines elektrisch-magnetischen Multipolelements findet die elektrische Isolation am Übergang der Halterungselemente PH, PH' zu den Polschuhen PS, PS' statt, wobei die mit Isolatoren IS, IS' versehenen Polschuhe PS, PS' durch eine Klebung oder eine Metall-Keramik-Verbindung auf den Halterungselementen PH, PH' befestigt sind.

Eine aus einem oder mehreren Multipolelementen bestehende Teilchenoptik erfüllt nur dann die gestellten Anforderungen, wenn die felderzeugenden Elemente (Polschuhe bei magnetischen Multipolen bzw. Elektroden bei elektrischen Multipolen) sehr genau, d. h. mit kleinstmöglichen Toleranzen gefertigt werden. Bei der Herstellung eines Multipolelements ist deshalb darauf zu achten,
- daß die felderzeugenden Elemente dieselbe Form besitzen,
- daß die felderzeugenden Elemente den gleichen Abstand zur optischen Achse OA aufweisen und
- daß die Abstände benachbarter felderzeugender Elemente gleich groß sind.

Besteht das teilchenoptische System aus mehreren Multipolelementen, muß man zusätzlich sicherstellen, daß die einzelnen Komponenten nicht gegeneinander verschoben oder verdreht sind (koaxiale bzw. azimutale Justierung).

Bei dem bekannten Verfahren zur Herstellung eines Korrektors bereitet insbesondere die koaxiale und azimutale Justierung Schwierigkeiten, da die elektrisch-magnetischen Multipolelementen einzeln gefertigt und anschließend zu einem Gesamtsystem zusammengefügt werden. Außerdem ist bei der Montage der Einzelelemente erhebliche Vorsicht geboten, um die Justierung der vor Beginn des Herstellungsprozesses gefertigten Polschuhe nicht zu zerstören.

Da die Polschuhe auf der der optischen Achse OA zugewandten Seite im allgemeinen von Zylinderflächen begrenzt sind, kann man sie durch schneidende Verfahren aus einem Kreiszylinder fertigen. Das erfindungsgemäße Verfahren sieht deshalb vor, das Multipolelement oder eine Mehrzahl von Multipolelementen MP1, MP2, MPn zunächst weitgehend aufzubauen, wobei anstelle vorgefertigter einzelner Polschuhe PS1, PS1', PS2, PSn zunächst die aus einem weichmagnetischen Material bestehenden Kreiszylinder Z1, Z2, Zn innerhalb der Joche J1, J2, Jn angeordnet und durch Halterungselemente PH1, PH1', PH2, PHn jeweils starr mit diesen verbunden werden (s. Fig. 2 a, b, die eine aus mehreren Quadrupolen bestehende Multipoloptik in Seitenansicht und Draufsicht zeigen). Nach Abschluß sämtlicher Montagearbeiten, die Kräfte auf die Polschuhe ausüben und damit die Justierung gefährden könnten, insbesondere aber nach dem Zusammenbau der Einzelelemente MP1, MP2, MPn zum Gesamtsystem, werden alle Zylinder Z1, Z2, Zn im selben Arbeitsgang getrennt und die Innenflächen der Polschuhe PS1, PS1', PS2, PSn geformt (s Fig. 2 c, d). Infolgedessen sind die einzelnen Multipolelemente MP1, MP2, MPn sehr genau mechanisch zueinander justiert. Selbstverständlich kommen nur kräftefreie Schneideverfahren, also insbesondere die Drahterosion zur Anwendung, um Verspannungen und Verformungen zu vermeiden.

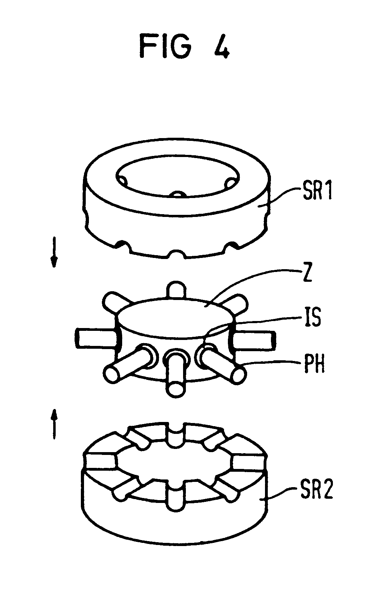

Wie die Fig. 4 zeigt, kann das Stahlrohr auch aus einem oberen SR1 und einem unteren Teil SR2 bestehen, in die man die vorgefertigte Einheit aus Kreiszylinder Z, Isolatoren IS und Halterungselementen PH einlegt und verklebt oder verlötet.

Die Erfindung ist selbstverständlich nicht auf die beschriebenen Ausführungsbeispiele beschränkt. So ist es ohne weiteres möglich, anstelle der Kreiszylinder Z1, Z2, Zn vorgeformte Einzelteile mit Übermaß zu verwenden.

Bei der Herstellung eines elektrischen Multipolelements benötigt man kein Joch und keine weit aus dem Stahlrohr herausragenden Halterungselemente. Zur Beaufschlagung der felderzeugenden Elektroden (diese können aus einem leitfähigen Material oder aus einem mit einer leitfähigen Schicht versehenen, nichtleitenden Material bestehen) mit einem Potential genügt eine einfache Kontaktierung.

## Patentansprüche

1. Multipolelement mit einem Halterungsteil (J), mit mehreren felderzeugenden Elementen (PS, PS'), die symmetrisch zu einer Symmetrieachse (OA) des Halterungsteils (J) angeordnet und durch Halterungselemente (PH, PH') starr mit diesem verbunden sind, und mit einem Spulensystem (SP, SP') zur magnetischen Erregung der felderzeugenden Elemente (PS, PS')
**dadurch gekennzeichnet,** daß die felderzeugenden Elemente (PS, PS') innerhalb eines Strahlrohrs (SR) angeordnet sind, wobei das Strahlrohr (SR) koaxial innerhalb des Halterungsteils (J) angeordnet ist und vakuumdichte Durchführungen (VD) für die Halterungselemente (PH, PH') aufweist.

2. Multipolelement nach Anspruch 1,
**dadurch gekennzeichnet,** daß das Spulensystem eine der Anzahl der felderzeugenden Elemente (PS, PS') entsprechende Anzahl von Spuleneinheiten (SP, SP') aufweist und daß die Spuleneinheiten (SP, SP') außerhalb des Strahlrohrs (SR) auf den Halterungselementen (PH, PH') angeordnet sind.

3. Multipolelement nach Anspruch 1 oder 2,
**dadurch gekennzeichnet,** daß eine auf einer Außenseite des Strahlrohrs (SR) angeordnete, mit dem jeweiligen Halterungselement (PH, PH') verbundene Metallkappe die Durchführungen vakuumdicht abschließt.

4. Multipolelement nach einem der Ansprüche 1 bis 3,
**kennzeichnet durch** stabförmige Halterungselemente (PH, PH').

5. Multipolelemet nach einem der Ansprüche 1 bis 4,
**dadurch gekennzeichnet,** daß die vakuumdichten Durchführungen elektrisch isolierend sind.

6. Multipolelementnach einem der Ansprüche 1 bis 5,
**dadurch gekennzeichnet,** daß das Strahlrohr (SR) aus einem nichtleitenden Material besteht.

7. Multipolelement nach Anspruch 6,
**dadurch gekennzeichnet,** daß das Strahlrohr (SR) aus einem keramischen Material besteht.

8. Multipolelement nach einem der Ansprüche 1 bis 7,
**dadurch gekennzeichnet,** daß das Halterungsteil (J) elektrisch isolierende Durchführungen für die Halterungselemente (PH, PH') aufweist und daß die Halterungselemente (PH, PH′) mit elektrischen Anschlüssen (A, A') zur Beaufschlagung der felderzeugenden Elemente (PS, PS') mit einem Potential (U, U') verbunden sind.

9. Multipolelement nach einem der Ansprüche 1 bis 4,
**dadurch gekennzeichnet,** daß die Halterungselemente (PH, PH') elektrisch isolierend mit den felderzeugenden Elementen (PS, PS') verbunden sind und daß die felderzeugenden Elemente (PS, PS') elektrische Anschlüsse (A, A') aufweisen.

10. Multipolelement nach einem der Ansprüche 1 bis 9,
**dadurch gekennzeichnet,** daß der Halterungsteil (J) ringförmig ausgebildet ist und aus einem einen magnetischen Fluß führenden Material besteht.

11. Multipolelement nach einem der Ansprüche 1 bis 10,
**dadurch gekennzeichnet,** daß die felderzeugenden Elemente (PS, PS') aus einem weichmagnetischen Material bestehen.

12. Verfahren zur Herstellung eines Multipolelements, nach einen das Ansprüche 1-11,
**dadurch gekennzeichnet,** daß ein aus dem Material der felderzeugenden Elemente (PS1, PS1', PS2, PSn) bestehender Körper (Z1, Z2, Zn) innerhalb eines Strahlrohrs (SR) angeordnet und gehaltert wird und daß die felderzeugenden Elemente (PS1, PS1', PS2, PSn) durch kräftefreies schneiden des Körpers (Z1, Z2, Zn) erzeugt werden.

13. Verfahren nach Anspruch 12,
**dadurch gekennzeichnet,** daß die felderzeugenden Elemente (PS1, PS1', PS2, PSn) durch Drahterosion des Körpers (Z1, Z2, Zn) erzeugt werden.

14. Verfahren nach Anspruch 12 oder 13,
**dadurch gekennzeichnet,** daß die felderzeugenden Elemente (PS1, PS1', PS2, PSn) aus einem zylinderförmigen Körper (Z1, Z2, Zn) geschnitten werden.

15. Verfahren nach einem der Ansprüche 12 bis 14,
**dadurch gekennzeichnet,** daß mehrere Körper (Z1, Z2, Zn) gleichzeitig durch kräftefreies schneiden bearbeitet werden.

## Claims

1. Multipole element with a mounting part (J), with several field-generating elements (PS, PS') which are arranged symmetrically with respect to an axis of symmetry (OA) of the mounting part (J) and rigidly connected to the latter by mounting elements (PH, PH') and with a coil system (SP, SP') for magnetic excitation of the field-generating elements (PS, PS'), characterised in that the field-generating elements (PS, PS') are arranged inside the beam tube (SR), the beam tube (SR) being arranged coaxially within the mounting part (J) and having Vacuum-tight ducts (VD) for the mounting elements (PH, PH').

2. Multipole element as claimed in claim 1, characterised in that the coil system has a number of coil units (SP, SP') corresponding to the number of field-generating elements (PS, PS') and that the coil units (SP, SP') are arranged outside the beam tube (SR) on the mounting elements (PH, PH').

3. Multipole element as claimed in claims 1 or 2, characterised in that a metal cap which is arranged on one outer side of the beam tube (SR) and is connected to the respective mounting element (PH, PH') closes off the ducts so that they are vacuum-tight.

4. Multipole element as claimed in one of claims 1 to 3, characterised by bar-shaped mounting elements (PH, PH').

5. Multipole element as claimed in one of claims 1 to 4, characterised in that the vacuum-tight ducts are electrically insulating.

6. Multipole element as claimed in one of claims 1 to 5, characterised in that the beam tube (SR) is made from a non-conductive material.

7. Multipole element as claimed in claim 6, characterised in that the beam tube (SR) is made from a ceramic material.

8. Multipole element as claimed in one of claims 1 to 7, characterised in that the mounting part (J) has electrically insulating ducts for the mounting elements (PH, PH') and that the mounting elements (PH, PH') are connected to electrical terminals (A, A') for applying a potential (U, U') to the field-generating elements (PS, PS').

9. Multipole element as claimed in one of claims 1 to 4, characterised in that the mounting elements (PH, PH') are connected to the field-generating elements in an electrically insulating manner and that the field-generating elements (PS, PS') have electrical terminals (A, A').

10. Multipole element as claimed in one of claims 1 to 9, characterised in that the mounting part (J) is of ring-shaped construction and made from a material which conducts a magnetic flux.

11. Multipole element as claimed in one of claims 1 to 10, characterised in that the field-generating elements (PS, PS') are made from a weakly magnetic material.

12. Method of producing a multipole element as claimed in one of clims 1 - 11, characterised in that a body (Z1, Z2, Zn) made from the material of the field-generating elements (PS1, PS1', PS2, PSn) is arranged and retained inside a beam tube (SR) and that the field-generating elements (PS1, PS1', PS2, PSn) are produced by force-free cutting of the body (Z1, Z2, Zn).

13. Method as claimed in claim 12, characterised in that the field-generating elements (PS1, PS1', PS2, PSn) are produced by wire erosion of the body (Z1, Z2, Zn).

14. Method as claimed in claims 12 or 13, characterised in that the field-generating elements (PS1, PS1', PS2, PSn) are cut out of a cylindrical body (Z1, Z2, Zn).

15. Method as claimed in one of claims 12 to 14, characterised in that several bodies (Z1, Z2, Zn) are machined simultaneously by force-free cutting.

## Revendications

1. Elément multipole comprenant une pièce de support (J), plusieurs éléments générateurs de champ (PS, PS') qui sont disposés symétriquement par rapport à un axe de symétrie (OA) de la pièce de support (J) et sont solidarisés avec cette dernière par des éléments de support (PH, PH'), ainsi qu'un système de bobinages (SP, SP') d'excitation magnétique des éléments générateurs de champ (PS, PS'), caractérisé en ce que les éléments générateurs de champ (PS, PS') sont disposés à l'intérieur d'un tube de faisceau (SR), le tube de faisceau (SR) étant disposé coaxialement à l'intérieur de la pièce de support (J) et comportant des traversées (VD) étanches au vide pour les éléments de support (PH, PH').

2. Elément multipole selon la revendication 1, caractérisé en ce que le système de bobinages comprend un nombre de bobinages individuels (SP, SP') qui correspond au nombre des éléments générateurs de champ (PS, PS') et en ce que les bobinages individuels (SP, SP') sont disposés à l'extérieur du tube de faisceau (SR) sur les éléments de support (PH, PH').

3. Elément multipole selon la revendication 1 ou 2, caractérisé en ce qu'un chapeau de métal disposé sur un côté extérieur du tube de faisceau (SR) et relié à chaque élément de support (PH; PH') ferme les traversées de manière étanche au vide.

4. Elément multipole selon l'une des revendications 1 à 3, caractérisé par des éléments de support en forme de barres (PH, PH').

5. Elément multipole selon l'une des revendications 1 à 4, caractérisé en ce que les traversées étanches au vide sont isolantes de l'électricité.

6. Elément multipole selon l'une des revendications 1 à 5, caractérisé en ce que le tube de faisceau (SR) est en un matériau non conducteur.

7. Elément multipole selon la revendication 6, caractérisé en ce que le tube de faisceau (SR) est en une matière céramique.

8. Elément multipole selon l'une des revendications 1 à 7, caractérisé en ce que la pièce de support (J) comporte des traversées isolantes de l'électricité pour les éléments de support (PH, PH') et en ce que les éléments de support (PH, PH') sont reliés à des connexions électriques (A, A') pour la mise des éléments générateurs de champ (PS, PS') à un potentiel (U, U').

9. Elément multipole selon l'une des revendications 1 à 4, caractérisé en ce que les éléments de support (PH, PH') sont reliés aux éléments générateurs de champ (PS, PS') de manière isolante de l'électricité et en ce que les éléments générateurs de champ (PS, PS') comportent des connexions électriques (A, A').

10. Elément multipole selon l'une des revendications 1 à 9, caractérisé en ce la pièce de support (J) est annulaire et en un matériau par lequel passe un flux magnétique.

11. Elément multipole selon l'une des revendications 1 à 10, caractérisé en ce que les éléments générateurs de champ (PS, PS') sont en un matériau à basse coércivité.

12. Procédé de réalisation d'un élément multipole selon l'une des revendications 1 à 11, caractérisé en ce qu'un corps (Z1, Z2, Zn) en le matériau des éléments générateurs de champ (PS1, PS1', PS2, PSn) est disposé et fixé à l'intérieur d'un tube de faisceau (SR) et en ce que les éléments générateurs de champ (PS1, PS1', PS2, PSn) sont produits par découpage du corps (Z1, Z2, Zn) sans application de force.

13. Procédé selon la revendication 12, caractérisé en ce que les éléments générateurs de champ (PS1, PS1', PS2, PSn) sont réalisés par érosion du corps (Z1, Z2, Zn) par un fil électrode.

14. Procédé selon la revendication 12 ou 13, caractérisé en ce que les éléments générateurs de champ (PS1, PS1', PS2, PSn) sont découpés dans un corps cylindrique (Z1, Z2, Zn).

15. Procédé selon l'une des revendications 12 à 14, caractérisé en ce que plusieurs corps (Z1, Z2, Zn) sont usinés simultanément par coupe sans application de force.
